# EUROPEAN PATENT SPECIFICATION

(11) **EP 0 948 756 B1**
(45) Date of publication and mention of the grant of the patent: **27.03.2002**
(21) Application number: 97952948.4
(22) Date of filing: 16.12.1997
(51) Int. Cl.: G03F 7/004, G03F 7/022

(54) **A METHOD FOR REDUCING METAL ION CONTAMINANTS IN PHOTORESIST COMPOSITIONS CONTAINING AN ORGANIC POLAR SOLVENT BY ION EXCHANGE**
VERFAHREN ZUR VERRINGERUNG METALLIONEN-VERUNREINIGUNGEN IN EIN POLARES LÖSUNSMITTEL ENTHALTENDEN PHOTORESISTZUSAMMENSETZUNGEN DURCH IONENAUSTAUSCH
PROCEDE POUR REDUIRE PAR ECHANGE IONIQUE LES CONTAMINANTS D'IONS METALLIQUES PAR UTILISATION DE COMPOSITIONS PHOTORESIST CONTENANT UN SOLVANT POLAIRE ORGANIQUE

(30) Priority: 17.12.1996 US 768749
(43) Date of publication of application: 13.10.1999
(73) Proprietor: Clariant Finance (BVI) Limited, Road Town, Tortola (VG)
(72) Inventor: RAHMAN, M., Dalil, Flemington, NJ 08822 (US)
(74) Representative: Hütter, Klaus, Dr.
(86) International application number: EP9707054
(87) International publication number: WO9827461

(56) References cited:
- WO-A-93/18437
- WO-A-94/12912
- WO-A-96/12214
- WO-A-96/20965
- US-A- 5 350 714
- US-A- 5 525 315
- DATABASE WPI Section Ch, Week 8943 Derwent Publications Ltd., London, GB; Class A21, AN 89-312247 XP002060438 & JP 01 228 560 A (HITACHI CHEM. CO., LTD.) , 12 September 1989

## Description

### BACKGROUND OF THE INVENTION

The present invention relates to a process for producing a photoresist composition having an extremely low level of metal ions. The present invention relates to a process for coating, imaging and developing such a light-sensitive photoresist compositions on a substrate.

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

Metal contamination has been a problem for a long time in the fabrication of high density integrated circuits and computer chips, often leading to increased defects, yield losses, degradation and decreased performance. In plasma processes, metals such as sodium and iron, when they are present in photoresists, can cause contamination especially during plasma stripping. However, these problems have been overcome to a substantial extent during the fabrication process. For example, by utilizing HCl gettering of the contaminants during a high temperature anneal cycle.

As semiconductor devices have become more sophisticated, these problems have become much more difficult to overcome. When silicon wafers are coated with a liquid positive photoresist and subsequently stripped off, such as with oxygen microwave plasma, the performance and stability of the semiconductor device is often seen to decrease. As the plasma stripping process is repeated, more degradation of the device frequently occurs. A primary cause of such problems has been found to be the metal contamination in the photoresist, particularly sodium and iron ions. Metal levels of less than 1.0 PPM in the photoresist have been found to adversely affect the properties of such semiconductor devices.

Novolak resins are frequently used the film forming polymeric binder in liquid photoresist formulations. These resins are typically produced by conducting a condensation reaction between formaldehyde and one or more multi-substituted phenols in the presence of an acid catalyst, such as oxalic acid.

There are two types of photoresist compositions, negative-working and positive-working. When negative-working photoresist compositions are exposed image-wise to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, the now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of less than one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

### SUMMARY OF THE INVENTION

The present invention relates to a process for producing a photoresist composition containing extremely low levels of metal ions and to a process for using such photoresists in producing semiconductor devices. The process of the subject invention utilizes a film forming resin, such as a hydroxystyrene polymer or a novolak resin obtained by condensing a mixture of methyl phenols and formaldehyde in presence of acid catalyst, in a solvent. After the condensation, the film forming resin, such as a novolak resin, is isolated, such as by distillation process, to remove impurities such as water, unreacted reactants, oligomers and monomers. A certain amount of film forming resin and a photoactive compound are mixed in a suitable photoresist solvent to make a photoresist composition. Another suitable solvent, i.e. an organic polar solvent, or mixture of solvents containing an organic polar solvent is added to the photoresist composition. The mixture is then passed through precleaned ion exchange resins to remove metal ion contaminants. The deionized mixture is then treated, preferably distilled, to remove the polar solvent or solvent mixture containing a polar solvent.

The photoresist composition obtained has an extremely low level of metal ions such as iron, sodium, potassium, calcium, magnesium, copper and zinc. The total metal ion level is preferably less than 100 PPB, more preferably less than 50 PPB, even more preferably less than 30 PPB. and most preferably less than 20 PPB. Sodium and iron are the most common metal ion contaminants and among the easiest to detect. The level of these metal ions serves as an indicator of the level of other metal ions.

The present invention provides a process for producing a photoresist composition having an extremely low level of metal ions.. In one embodiment, the process utilizes an acidic ion (cation) exchange resin to purify the photoresist composition which has been dissolved in a mixture of a polar and a non polar solvent, and in a particularly preferred embodiment, uses the cation exchange resin followed by purification of the same solution using an anion ion exchange resin, followed by removing the polar solvent or mixture of solvents, such as by low temperature vacuum distillation. The subject process comprises:
a) washing an acidic ion exchange resin with water, preferably deionized water, followed by washing with a mineral acid solution (e.g. a 5-98% solution of sulfuric, nitric or hydrochloric acid), followed by washing again with DI water and thereby reducing the level of total sodium and iron ions in the ion exchange resin to less than 100 PPB each, preferably less than 50 PPB each, and most preferably no more than 20 PPB, which is equivalent to 18 megaohms conductivity of the final effluent;
b) washing an anionic ion exchange with DI water, followed by washing with a mineral acid solution (e.g. a 5-98% solution of sulfuric, nitric or hydrochloric acid), followed by washing again with DI water, then washing with an ammonium hydroxide solution, preferably a 4-28% electronic grade, followed by washing with DI water again, and thereby reducing the level of sodium and iron ions in the anionic ion exchange resin to less than 100 PPB each, preferably less than 50 PPB and most preferably no more than 20 PPB each; which is equivalent to 18 megaohms conductivity of the final effluent;
c) dissolving a photosensitizer and a film forming resin in a photoresist solvent selected from the group consisting of propylene glycol mono-alkyl ether, propylene glycol alkyl ether acetate, ethyl-3-ethoxypropionate, ethyl lactate, mixtures of ethyl-3-ethoxy-propionate and ethyl lactate, 2-heptanone, butyl acetate, xylene, diglyme and ethylene glycol monoethyl ether acetate and thereby providing a photoresist composition;
d) adding to the photoresist composition of step c) a solvent comprising a C₁-C₃-alcohol, acetone, tetralydrofuran or a mixture thereof;
e) passing the photoresist composition of step d) through the cation ion exchange resin of step a), followed by passing said photoresist composition through the anion ion exchange resin of step b), and thereby reducing the level of sodium and iron ions in such photoresist composition to less than 100 PPB each, preferably less than 50 PPB, more preferably less than 25 PPB and most preferably less than 10 PPB each;
f) removing the solvent specified in step d) from the photoresist composition of step e), such as by distilling, preferably low temperature distillation under vacuum, optionally followed by adjusting the level of the photoresist solvent, and thereby providing a photoresist composition having a level of sodium and iron ions of less than 100 PPB each, preferably 50 PPB, more preferably less than 25 PPB, and most preferably less than 10 PPB each.

The invention further provides a method for producing a semiconductor device by producing a photo-image on a substrate by coating a suitable substrate with a positive working photoresist composition by:
a) providing a photoresist composition according to the aforementioned process;
b) coating the photoresist composition of step a) onto a suitable substrate;
c) heat treating the coated substrate of step b) until substantially all of the solvent is removed; image-wise exposing the photosensitive composition and removing the image-wise exposed areas of such composition with a suitable developer, such as an aqueous alkaline developer. Optionally one may perform a baking of the substrate either immediately before or after the removing step.

It has been found that metal ions cannot be removed from a liquid photoresist composition to provide an extremely low level of metal ions unless: 1) such photoresist composition is mixed with an organic polar solvent or a solvent mixture containing an organic polar solvent; 2) a cationic ion exchange resin and an anionic ion exchange are washed and treated as described above; and 3) both the cationic ion exchange resin and the anionic ion exchange resin are subsequently washed with a solvent which is compatible with the solvent or solvents in which the photoresist is dissolved. It was unexpectedly found that addition of an organic polar solvent such as a C₁-C₃ alkyl alcohol (e.g. methanol, ethanol), acetone, tetrahydrofuran (THF) or mixtures thereof to a photoresist dissolved in a photoresist solvent such as propylene glycol methyl ether acetate (PGMEA), greatly facilitatyes the removal of metal ions to provide a photoresist composition containing an extremely low level of metal ion contamination.

### DETAILED DESCRIPTION OF THE PREFERRED EMBODIMENT

An acidic (cationic) ion exchange resin, such as a styrene/divinylbenzene cation ion exchange resin, is utilized in the present process. Ion exchange resins are available from Rohm and Haas Company, e.g. AMBERLYST® 15 cationic ion exchange resin, AMBERLYST® 21 anionic ion exchange resin or IRC® 718 anionic ion exchange resin. These resins typically contain as much as 80,000 to 200,000 PPB of sodium and iron ions.

The present invention provides a process for producing a photoresist composition and a process for producing semiconductor devices using such a photoresist composition. The photoresist composition is formed by providing an admixture of a photosensitizer, a film forming novolak resin and a suitable photoresist solvent. Suitable solvents for such photoresists include propylene glycol mono-alkyl ether, propylene glycol alkyl (e.g. methyl) ether acetate, ethyl-3-ethoxypropionate, ethyl lactate, mixtures of ethyl-3-ethoxypropionate and ethyl lactate, 2-heptanone, butyl acetate, xylene, diglyme, ethylene glycol monoethyl ether acetate. The preferred solvents are propylene glycol methyl ether acetate (PGMEA), ethyl lactate and ethyl-3-ethoxypropionate (EEP).

Other optional ingredients such as colorants, dyes, anti-striation agents, leveling agents, plasticizers, adhesion promoters, speed enhancers, solvents and such surfactants as non-ionic surfactants may be added to the solution of film forming resin, sensitizer and photoresist solvent before the photoresist composition is coated onto a substrate. Examples of dye additives that may be used together with the photoresist compositions of the present invention include Methyl Violet 2B (C.I. No. 42535), Crystal Violet (C.I. 42555). Malachite Green (C.I. No. 42000), Victoria Blue B (C.I. No. 44045) and Neutral Red (C.I. No. 50040) at one to ten percent weight levels, based on the combined weight of PHS and sensitizer. The dye additives help provide increased resolution by inhibiting back scattering of light off the substrate.

Anti-striation agents may be used at up to about a five percent weight level, based on the combined weight of novolak and sensitizer. Plasticizers which may be used include, for example, phosphoric acid tri-(beta-chloroethyl)-ester; stearic acid; dicamphor; polypropylene; acetal resins; phenoxy resins; and alkyl resins, at about one to ten percent weight levels, based on the combined weight of novolak and sensitizer. The plasticizer additives improve the coating properties of the material and enable the application of a film that is smooth and of uniform thickness to the substrate.

Adhesion promoters which may be used include, for example, beta-(3,4-epoxycyclohexyl)-ethyltrimethoxysilane; p-methyl-disilane-methyl methacrylate; vinyltrichlorosilane; and gamma-amino-propyl triethoxysilane up to about a 4 percent weight level, based on the combined weight of film forming resin and sensitizer. Development speed enhancers that may be used include, for example, picric acid, nicotinic acid or nitrocinnamic acid up to about a 20 percent weight level, based on the combined weight of novolak and sensitizer. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhances will also cause a larger loss of photoresist coating from the unexposed areas.

The solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to about 10% weight levels, based on the combined weight of novolak and sensitizer.

The prepared photoresist solution, can be applied to a substrate by any conventional method used in the photoresist art, including dipping, spraying, whirling and spin coating. When spin coating, for example, the resist solution can be adjusted with respect to the percentage of solids content, in order to provide coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexa-alkyl disilazane.

The photoresist composition solution is then coated onto the substrate, and the substrate is treated at a temperature from about 70°C to about 110°C for from about 30 seconds to about 180 seconds on a hot plate or for from about 15 to about 90 minutes in a convection oven. This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the temperature is from about 85°C to about 95°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist is then optionally subjected to a post exposure second baking or heat treatment either before or after development. The heating temperatures may range from about 90°C to about 120°C, more preferably from about 100°C to about 110°C. The heating may be conducted for from about 30 seconds to about 2 minutes, more preferably from about 60 seconds to about 90 seconds on a hot plate or about 30 to about 45 minutes by convection oven.

The exposed photoresist-coated substrates are developed to remove the image-wise exposed areas by immersion in an alkaline developing solution or developed by spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution. The photoresist compositions of the present invention are resistant to acid-base etching solutions and provide effective protection for the unexposed photoresist-coating areas of the substrate.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention. Unless otherwise stated all parts and percents are by weight and all molecular weights are weight average.

### Example 1

55 grams of dry AMBERLYST® 15 anionic ion exchange resin (A-15) beads were placed in a conical flask and deionized (DI) water was added so that all of the resin beads were under water. The flask was sealed and allowed to stand overnight to swell the resin beads. The next morning the water was decanted, DI water added to cover the resin beads and the flask was shaken slowly. The water was again decanted. The rinsing with DI water and decanting steps were repeated three additional times. The resulting slurry of ion exchange resin was poured into glass column equipped with a porous disk and a stopcock. The resin was allowed to settle to the bottom and the column was back flushed with deionized water for 25 minutes. The resin was again allowed to settle to the bottom.

The bed length was measured and the bed volume was found to be 100 ml. A 10 percent sulfuric acid solution was passed down through the resin bed at a rate of about 10 ml./min.. 6 bed volumes of the acid solution were passed through the resin bed. 60 bed volumes of deionized water were then passed down through the resin bed at about the same flow rate. The pH of the effluent water was measured to assure that it matched the pH of 6 for fresh deionized water. Two bed volumes of electronic grade acetone were passed through the column.

80 grams of wet AMBERLYST® 21 anionic ion exchange resin (A-21) beads were placed in a conical flask and DI water was added so that all of the resin beads were under water. The flask was sealed and allowed to stand overnight to swell the resin beads. The next morning the water was decanted, DI water was added to cover the resin beads and the flask was shaken slowly. The water was again decanted. The rinsing with DI water and decanting steps were repeated three additional times. The resulting slurry of anionic ion exchange resin was poured into a glass column having a diameter equipped with a porous disk and a stopcock. The resin was allowed to settle to the bottom and the column was back flushed with deionized water for 25 minutes. The resin was again allowed to settle to the bottom.

The bed length was measured and the bed volume was calculated as 125 ml. An ammonium hydroxide solution (6%, 6 bed volumes) was passed through the anionic ion exchange resin column at the same rate, followed by about 60 bed volumes of DI water, to remove ammonium hydroxide. The pH of the effluent water was measured to assure that it matched the pH of 6 for fresh DI water. 2 bed volumes of electronic grade acetone were passed throught the anionic ion exchange resin column to substantially remove water.

A photoresist in PGMEA solution (AZ® 7511 photoresist obtained from AZ Photoresist Products, Hoechst Celanese Corp.) was mixed with an equal volume of electronic grade acetone and the mixture was passed through the precleaned AMBERLYST® 15 cationic ion exchange column with a 10 minute residence time, followed by passing the same mixture through the precleaned AMBERLYST ® 21 anionic ion exchange resin column with a 20 minute residence time. Acetone was then distilled off at a temperature of 60°C and a vacuum of 20 mm Hg to yield a photoresist dissolved in PGMEA. The results of metal ion tests in PPB before, during and after the process are shown in Table 1 below.

**Table 1**

| Metal Ions | Resist before | After A-15 | After A-21 | After Distillation |
|---|---|---|---|---|
| Na | 167 | <5 | <5 | 10 |
| Fe | 158 | 98 | <5 | 12 |

### Example 2

The photoresist from example 1 was coated on a hexemethyldisilazane (HMDS) primed silicon wafer to 1.29 mm thickness and soft baked at 110°C for 60 seconds on the SVG® 8100 I-line hot plate. The untreated reference sample was also coated to 1.29 mm thickness by the same procedure. The exposure matrix was printed on the coated wafers using a 0.54 NA NIKON® i-line stepper and a NIKON® resolution reticle. The exposed wafers were post exposure baked (PEB) at 110°C for 60 seconds on an in line hot plate. The wafers were then developed using AZ® 300 MIF 2.38% tetramethyl ammonium hydroxide (TMAH) developer. The developed wafers were examined using a HITACHI S®-400 scanning electron microscope (SEM). A nominal dose (Dose to Print, DTP) is measured at the best focus, the dose required to precisely replicate a given feature. DTP, resolution (RES.) and focus latitude (FL), in microns, were measured and are shown below: in Table 2 below:

**Table 2**

| Sample | DTC mJ/cm² | DTP mJ/cm² | RES. micron | DOF micron |
|---|---|---|---|---|
| Control | 102 | 175 | 0.4 | -0.6/0.2 |
| Treated | 110 | 200 | 0.4 | -0.4/0.4 |
| DTC = Dose To Clear | | | | |
| DTP = Does to Print | | | | |
| RES. = Resolution | | | | |
| DOF = Depth of Focus | | | | |

### Example 3

The procedure of Example 1 was repeated using 502.56 g of AZ ®7710 photoresist dissolved in PGMEA (available from AZ Photoresist Products, Hoechst Celanese Corp.) which was placed in a beaker. 250 g of electronic grade acetone was added, the mixture stirred and then passed through a cleaned AMBERLYST® 15 column, according to the procedure of Example 2, followed by passing the photoresist through a cleaned AMBERLYST® 21 column, according to the procedure of Example 2, but with a residence time of 12 minutes. The acetone was distilled off to obtain a photoresist composition. Metal ion analysis results before and after each treatment is shown in Table 3 below:

**Table 3**

| Metal Ions | AZ® 7710 Control | Acetone Solution | After A-15 Treatment | After A-21 Treatment | After Distillation |
|---|---|---|---|---|---|
| Na | 37 | 16 | 12 | <5 | 8 |
| K | 11 | 8 | 9 | <5 | 7 |
| Fe | 97 | 42 | 12 | <5 | <5 |
| Cr | 11 | <5 | <5 | <5 | <5 |
| Cu | 11 | <5 | <5 | <5 | <5 |
| Ni | 9 | <5 | <5 | <5 | <5 |
| Ca | 17 | 9 | 48 | <5 | 7 |
| Al | 6 | <5 | <5 | <5 | <5 |

### Example 4

The photoresist composition from example 2 was coated onto an HMDS primed silicon wafer to 1.29 mm thickness using soft bake at 110°C for 60 seconds on the SVG 8100 I-line hot plate. An untreated reference sample was also coated to 1.29 mm thickness using the same procedure. The exposure matrix is printed on the coated wafers using a 0.54 NA NIKON® i-line stepper and a NIKON® resolution reticle. The exposed wafers were PEB at 110°C for 60 seconds on a in line hot plate. The wafers were then developed using AZ® 300 MIF TMAH developer. The developed wafers were examined using a HITACHI S-400 SEM. A nominal dose (Dose to Print, DTP) was measured at the best focus, the dose required to precisely replicate a given feature. DTP, resolution and focus latitude (FL), in microns, were measured and are shown below in Table 4:

**Table 4**

| Sample | DTC mJ/cm² | DTP mJ/cm² | RES. microns | DOF microns |
|---|---|---|---|---|
| Control | 138 | 280 | 0.32 | -0.6/0.2 |
| Treated | 150 | 280 | 0.32 | -0.6/0.2 |

### Example 5

Example 1 was repeated using 1062.95 g of AZ ®7710 photoresist which was placed in a beaker. 533.52 g of electronic grade acetone was added, stirred and then passed through a filter through a cleaned AMBERLYST® 15 cationic ion exchange column, according to the procedure of Example 2, followed by passing the photoresist through a cleaned IRC®-718 anionic ion exchange column, instead of AMBERLYST ® 21 column, according to the procedure of Example 2, with a residence time 12 minutes. The acetone was distilled off to obtain a photoresist composition. Metal ion analysis result before and after each treatment are shown in Table 5 below:

**Table 5**

| Metal Ions | AZ® 7710 Control | Acetone Solution | After A-15 Treatment | After IRC® 718 Treatment | After Distillation |
|---|---|---|---|---|---|
| Na | 23 | 22 | <5 | <5 | 16 |
| K | 8 | 10 | <5 | <5 | 14 |
| Fe | 92 | 68 | 12 | 17 | 16 |
| Cr | 8 | <5 | <5 | <5 | <5 |
| Cu | <5 | <5 | <5 | <5 | <5 |
| Ni | 6 | <5 | <5 | <5 | <5 |
| Ca | 44 | 201 | 9 | <5 | 5 |
| Al | 7 | <5 | <5 | <5 | <5 |

### Example 6

The photoresist from example 2 was coated on an HMDS primed silicon wafer to 1.29 mm thickness, using a soft bake at 110°C for 60 seconds on the SVG ® 8100 I- line hot plate. The untreated reference sample was also coated to 1.29 mm thickness by the same procedure. The exposure matrix was printed on the coated wafers using a 0.54 NA NIKON® i-line stepper and a NIKON® resolution reticle. The exposed wafers were PEB at 110°C for 60 seconds on an in line hot plate. The wafers were then developed using AZ® 300 MIF TMAH developer. The developed wafers were examined using a HITACHI® S-400 SEM. A nominal dose (Dose to Print, DTP) was measured at the best focus, the dose required to precisely replicate a given feature. DTP, resolution and focus latitude (FL), in microns, were measured and are shown below in Table 6:

**Table 6**

| Sample | DTC mJ/cm² | DTP mJ/cm² | RES. microns | DOF microns |
|---|---|---|---|---|
| Control | 132 | 275 | 0.32 | -0.6/0.4 |
| Treated | 120 | 230 | 0.34 | -0.6/0.4 |

## Claims

1. A method for producing a photoresist comprising:
a) washing a cationic ion exchange resin with water, washing said cationic ion exchange resin with a mineral acid solution, followed by washing said cationic ion exchange resin again with water and thereby reducing the level of sodium and iron ions in the cationic ion exchange resin to less than 100 PPB;
b) washing an anionic ion exchange resin with water, washing said anionic ion exchange resin with a mineral acid solution, followed by washing said anionic ion exchange resin again with water, washing said anionic ion exchange resin with an ammonium hydroxide, followed by washing with water again, and thereby reducing the total sodium and iron ions to less than 100 APB;
c) dissolving a photosensitizer and a film forming resin in a photoresist solvent selected from the group consisting of propylene glycol mono-alkyl ether, propylene glycol alkyl ether acetate, ethyl-3-ethoxypropionate, ethyl lactate, mixtures of ethyl-3-ethoxy-propionate and ethyl lactate, 2-heptanone, butyl acetate, xylene, diglyme and ethylene glycol monoethyl ether acetate and thereby providing a photoresist composition;
d) adding to the photoresist composition of step c) a solvent comprising a C₁-C₃ alkyl alcohol, acetone, tetrahydrofuran or a mixture thereof;
e) passing the photoresist composition of step d) through the cation ion exchange resin of step a), followed by passing said photoresist composition of step d) through the anionic ion exchange resin of step b);
f) removing the solvent comprising a C₁-C₃ alkyl alcohol, acetone, tetrahydrofuran or a mixture thereof, and thereby providing a photoresist composition having a level of sodium and iron ions of less than 100 PPB each.

2. The method of claim 1 wherein said cationic ion exchange resin and said anionic ion exchange resin are each washed to reduce the sodium and iron ion level to less than 50 PPB each.

3. The method of claim 1 wherein in step d) said solvent is methanol, ethanol, acetone, or tetrahydrofuran.

4. The method of claim 1 the photoresist composition of step f) has a sodium and iron ion of less than 50 PPB each.

5. A method for producing a semiconductor device by producing a photo-image on a suitable substrate comprising:
a) coating a suitable substrate with the photoresist composition of claim 1;
b) heat treating the coated substrate of step a) until substantially all of the solvent is removed;
c) image-wise exposing the substrate of step b); and
d) removing the image-wise exposed areas of the photoresist composition on the substrate of step c) with a suitable developer.

6. The method of claim 5 wherein said cationic ion exchange resin and said anionic ion exchange resin are each washed to reduce the sodium and iron ion level to less than 50 PPB each.

7. The method of claim 5 wherein the photoresist composition has a sodium and iron ion level of less than 50 PPB each.

8. The method of claim 5 wherein said photoresist solvent is selected from the group consisting of propylene glycol methyl ether acetate, 2-heptanone, ethyl-3-ethoxypropionate, ethyl lactate.

9. The method of claim 5 wherein said developer comprises an aqueous alkaline developer.

10. The method of claim 5 further comprising the step of baking the coated substrate immediately before or after the removing step.

## Patentansprüche

1. Verfahren zur Herstellung eines Photoresists, das aus folgenden Schritten besteht:
a) Waschen eines Kationenaustauscherharzes mit Wasser, Waschen des genannten Kationenaustauscherharzes mit einer Mineralsäure-Lösung, danach erneutes Waschen des genannten Kationenaustauscherharzes mit Wasser, wobei der Gehalt des Kationenaustauscherharzes an Natrium- und Eisenionen auf unter 100 ppb abgesenkt wird;
b) Waschen eines Anionenaustauscherharzes mit Wasser, Waschen des genannten Anionenaustauscherharzes mit einer Mineralsäure-Lösung, danach erneutes Waschen des genannten Anionenaustauscherharzes mit Wasser, Waschen des genannten Anionenaustauscherharzes mit einem Ammoniumhydroxid, anschließend wieder Waschen mit Wasser, wobei der Gesamtgehalt an Natrium- und Eisenionen auf unter 100 ppb abgesenkt wird;
c) Lösen eines Photosensibilisators und eines filmbildenden Harzes in einem Photoresistlösungsmittel, das aus der Gruppe Propylenglycolmonoalkylether, Propylenglycolalkyletheracetat, Ethyl-3-ethoxypropionat, Ethyllactat, Gemische von Ethyl-3-ethoxypropionat und Ethyllactat, 2-Heptanon, Butylacetat, Xylol, Diglyme und Ethylenglycolmonoethyletheracetat ausgewählt wurde, wobei eine Photoresistzubereitung entsteht;
d) Versetzen der Photoresistzubereitung gemäß Schritt c) mit einem Lösungsmittel wie C₁-C₃-Alkylalkohol, Aceton, Tetrahydrofuran oder ein Gemisch dieser Substanzen;
e) Leiten der Photoresistzubereitung gemäß Schritt d) durch das Kationenaustauscherharz gemäß Schritt a), danach Leiten der genannten Photoresistzubereitung gemäß Schritt d) durch das Anionenaustauscherharz gemäß Schritt b);
f) Entfernen des Lösungsmittels - C₁-C₃-Alkylalkohol, Aceton, Tetrahydrofuran oder ein Gemisch dieser Substanzen - und dadurch Herstellung einer Photoresistzubereitung mit einem Gehalt an Natrium- und Eisenionen unter jeweils 100 ppb.

2. Verfahren gemäß Anspruch 1, wobei das genannte Kationenaustauscherharz und das genannte Anionenaustauscherharz zur Herabsetzung des Gehalts an Natrium- und Eisenionen auf jeweils unter 50 ppb einzeln gewaschen werden.

3. Verfahren gemäß Anspruch 1, wobei das genannte Lösungsmittel gemäß Schritt d) Methanol, Ethanol, Aceton oder Tetrahydrofuran ist.

4. Verfahren gemäß Anspruch 1, wobei die Photoresistzubereitung gemäß Schritt f) einen Gehalt an Natrium- und Eisenionen von jeweils unter 50 ppb aufweist.

5. Verfahren zur Herstellung eines Halbleiterelements durch Herstellung einer Photoabbildung auf einem geeigneten Träger, wobei dieses Verfahren aus folgenden Schritten besteht:
a) Beschichten eines geeigneten Trägers mit der Photoresistzubereitung gemäß Anspruch 1;
b) Wärmebehandlung des beschichteten Trägers gemäß Schritt a) bis zur Entfernung praktisch des gesamten Lösungsmittels;
c) abbildungsgemäße Belichtung des Trägers gemäß Schritt b) und
d) Entfernen der abbildungsgemäß belichteten Bereiche der Photoresistzubereitung auf dem Träger gemäß Schritt c) mit einem geeigneten Entwickler.

6. Verfahren gemäß Anspruch 5, wobei das genannte Kationenaustauscherharz und das genannte Anionenaustauscherharz zur Herabsetzung des Gehalts an Natrium- und Eisenionen auf jeweils unter 50 ppb einzeln gewaschen werden.

7. Verfahren gemäß Anspruch 5, wobei die Photoresistzubereitung einen Gehalt an Natrium- und Eisenionen unter jeweils 50 ppb aufweist.

8. Verfahren gemäß Anspruch 5, wobei das genannte Photoresistlösungsmittel aus der Gruppe Propylenglycolmethyletheracetat, 2-Heptanon, Ethyl-3-ethoxypropionat und Ethyllactat ausgewählt wird.

9. Verfahren gemäß Anspruch 5, wobei der genannte Entwickler ein wäßrig-alkalischer Entwickler sein kann.

10. Verfahren gemäß Anspruch 5, wobei der beschichtete Träger unmittelbar vor oder nach dem Schritt des Entfernens getrocknet wird.

## Revendications

1. Procédé pour la production d'un photorésist comprenant les étapes consistant :
a) à laver une résine échangeuse d'ions cationique avec de l'eau, à laver ladite résine échangeuse d'ions cationique avec une solution d'acide inorganique, suivi par le lavage de ladite résine échangeuse d'ions cationique de nouveau avec de l'eau, réduisant ainsi la teneur en ions sodium et fer dans la résine échangeuse d'ions cationique jusqu'à moins de 100 ppb ;
b) à laver une résine échangeuse d'ions anionique avec de l'eau, à laver ladite résine échangeuse d'ions anionique avec une solution d'acide inorganique, suivi par le lavage de ladite résine échangeuse d'ions anionique de nouveau avec de l'eau, à laver ladite résine échangeuse d'ions anionique avec un hydroxyde d'ammonium, suivi par un nouveau lavage avec de l'eau, réduisant ainsi la teneur en ions sodium et fer totaux jusqu'à moins de 100 ppb ;
c) à dissoudre un photosensibilisateur et une résine filmogène dans un solvant de photorésist choisi dans le groupe formé par l'éther monoalkylique de propylèneglycol, l'acétate d'éther alkylique de propylèneglycol, le 3-éthoxypropinate d'éthyle, le lactate d'éthyle, les mélanges de 3-éthoxypropionate d'éthyle et de lactate d'éthyle, la 2-heptanone, l'acétate de butyle, le xylène, le diglyme et l'acétate d'éther monoéthylique d'éthylèneglycol, fournissant ainsi une composition de photorésist ;
d) à ajouter à la composition de photorésist de l'étape c) un solvant comprenant un alcool alkylique en C₁ à C₃, l'acétone, le tétrahydrofuranne ou un de leurs mélanges ;
e) à faire passer la composition de photorésist de l'étape d) à travers la résine échangeuse d'ions cationique de l'étape a), suivi par le passage de ladite composition de photorésist de l'étape d) à travers la résine échangeuse d'ions anionique de l'étape b) ;
f) à éliminer le solvant comprenant un alcool alkylique en C₁ à C₃, l'acétone, le tétrahydrofuranne ou un de leurs mélanges, fournissant ainsi une composition de photorésist possédant une teneur en ions sodium et fer inférieure à 100 ppb chacun.

2. Procédé selon la revendication 1, dans lequel ladite résine échangeuse d'ions cationique et ladite résine échangeuse d'ions anionique sont chacune lavées pour réduire la teneur en ions sodium et fer jusqu'à moins de 50 ppb chacune.

3. Procédé selon la revendication 1, dans lequel, dans l'étape d), ledit solvant est le méthanol, l'éthanol, l'acétone, ou le tétrahydrofuranne.

4. Procédé selon la revendication 1, dans lequel la composition de photorésist de l'étape f) possède une teneur en ions sodium et fer inférieure à 50 ppb chacun.

5. Procédé pour la production d'un dispositif à semi-conducteur pour la production d'une image photographique sur un substrat approprié comprenant les étapes consistant :
a) à revêtir un substrat approprié avec la composition de photorésist selon la revendication 1 ;
b) à traiter thermiquement le substrat revêtu de l'étape a) jusqu'à éliminer pratiquement tout le solvant ;
c) à exposer selon une image le substrat de l'étape b) ; et
d) à éliminer les zones exposées selon une image de la composition de photorésist sur le substrat de l'étape c) avec un révélateur approprié.

6. Procédé selon la revendication 5, dans lequel ladite résine échangeuse d'ions cationique et ladite résine échangeuse d'ions anionique sont chacune lavées pour réduire la teneur en ions sodium et fer jusqu'à moins de 50 ppb chacune.

7. Procédé selon la revendication 5, dans lequel la composition de photorésist possède une teneur en ions sodium et fer inférieure à 50 ppb chacun.

8. Procédé selon la revendication 5, dans lequel ledit solvant de photorésist est choisi dans le groupe formé par l'acétate d'éther méthylique de propylèneglycol, la 2-heptanone, le 3-éthoxypropionate d'éthyle, le lactate d'éthyle.

9. Procédé selon la revendication 5, dans lequel ledit révélateur comprend un révélateur basique aqueux.

10. Procédé selon la revendication 5, comprenant de plus l'étape consistant à cuire le substrat revêtu immédiatement avant ou après l'étape d'élimination.
